# EUROPÄISCHE PATENTSCHRIFT

(11) **EP 0 503 717 B1**
(45) Veröffentlichungstag und Bekanntmachung des Hinweises auf die Patenterteilung: **02.06.1999**
(21) Anmeldenummer: 92200623.4
(22) Anmeldetag: 04.03.1992
(51) Int. Cl.: G06F 1/025, H04B 7/212

(54) **Einrichtung zur Erzeugung von Digitalsignalen**
Digital signal generator
Générateur de signaux numériques

(30) Priorität: 11.03.1991 DE 4107729
(43) Veröffentlichungstag der Anmeldung: 16.09.1992
(73) Patentinhaber: Philips Patentverwaltung GmbH, 22335 Hamburg (DE); Koninklijke Philips Electronics N.V., 5621 BA Eindhoven (NL)
(72) Erfinder: Schöffel, Peter, Dr., W-8551 Kirchrüsselbach (DE)
(74) Vertreter: Volmer, Georg, Dipl.-Ing.

(56) Entgegenhaltungen:
- EP-A- 0 408 439
- DE-A- 3 417 816

## Beschreibung

Die Erfindung betrifft eine Einrichtung zur Erzeugung von sich im wesentlichen in einem vorgebbaren Zeitrahmen wiederholenden und mit einem ersten Takt getakteten Digitalsignalen für ein Funkübertragungssystem.

Eine derartige Einrichtung wird beispielsweise in Sende- bzw. Empfangsgeräten (Funkgeräten) für das künftige gesamteuropäische Mobilfunksystem benötigt. Bei diesem Mobilfunksystem werden Sprachsignale in digitalisierter Form zusammen mit anderen digitalen Signalen in einem Zeit-Vielfachzugriffs-Verfahren (Time division multiple access TDMA) übertragen. Dabei ist eine präzise zeitliche Steuerung verschiedener Funktionen notwendig. Hierzu ist eine Vielzahl von Steuersignalen erforderlich, die meist periodischen Verlauf zeigen, d.h. sich in einem vorgebbaren Zeitrahmen zyklisch wiederholen. Darüber hinaus müssen diese Steuersignale aber auch abhängig von zahlreichen unterschiedlichen Betriebsbedingungen individuell beeinflussbar sein. Die Steuersignale können aus dem Signal eines als Timer bezeichneten zentralen Taktgebers abgeleitet werden. Dieser basiert im wesentlichen auf einem Zähler, der bei Überlauf oder dem Erreichen eines vorgegebenen Wertes eine Unterbrechung (Interrupt) des Steuerrechners des Funkgerätes auslöst und/oder direkt externe Steuersignale beeinflusst. Werden auf diese Weise zahlreiche Steuersignale mit hoher zeitlicher Auflösung erzeugt, so wird der Steuerrechner sehr stark belastet. Eine andere Möglichkeit besteht in der Erzeugung der Steuersignale mittels spezieller Schaltwerke. Die Steuersignale sind dabei fest vorgegeben, so daß sich erhebliche Einschränkungen hinsichtlich der Flexibilität bei der Anwendung, z.B. bei der Änderung einzelner Steuersignale, ergeben.

Aus der DE 34 17 816 A1 ist ein programmierbares Schaltnetz zum Erzeugen von vorgegebenen Folgen von Binärsignalen bekannt. In einem Speicher sind Datenwörter gespeichert, die den Momentanwerten der Binärsignale zugeordnet sind. Die Datenwörter werden in Abhängigkeit von an den Speicher angelegten Adressenwörtern zeitlich nacheinander ausgelesen. Jedem Datenwort ist mindestens ein Steuerzeichen zugeordnet. Gleichzeitig mit dem Auslesen der Datenwörter werden die entsprechenden Steuerzeichen ausgelesen. Wenn die Steuerzeichen einen ersten Binärwert aufweisen, wird die angelegte Adresse schrittweise fortgeschaltet. Wenn die Steuerzeichen einen zweiten Binärwert annehmen, wird die angelegte Adresse auf einen vorgegebenen Wert eingestellt.

Aus der EP 0 408 439 A1 ist eine Einrichtung zum Erzeugen von Digitalsignalen bekannt, bei der zur Erzeugung der Digitalsignale ebenfalls ein Speicher vorgesehen ist, der mittels eines Adreßzählers adressiert wird. Entsprechend der Adressierung durch den Adreßzähler werden entsprechend der unter den jeweiligen Adressen abgelegten Daten zyklische Signale erzeugt. Zur Veränderung des Zählerstandes des Adreßzählers werden diesem von einem Impulsgenerator erzeugte Signale mit einer vorgebbaren Taktfrequenz zugeführt. Die Taktfrequenz wird dabei mittels von einem Prozessor erzeugter Steuersignale bestimmt. Nach einem Signalzyklus wird an einem Ausgang des Speichers ein Steuersignal abgegeben, das ein Rücksetzen des Adreßzählers bewirkt.

Der Erfindung liegt die Aufgabe zugrunde, eine Einrichtung der eingangs genannten Art anzugeben, die auf einfache Weise die Erzeugung einer Vielzahl von Digitalsignalen mit hoher zeitlicher Auflösung und Flexibilität in der Anwendung ermöglicht.

Diese Aufgabe wird bei einer Einrichtung der eingangs genannten Art dadurch gelöst, daß
- ein Schreib-Lese-Speicher vorgesehen ist, der zur Speicherung von Signalverläufen der Digitalsignale dient;
- eine dem Schreib-Lese-Speicher zugeordnete Adreßeinrichtung zur Selektierung von im Schreib-Lese-Speicher gespeicherten Signalverläufen für die Erzeugung der Digitalsignale vorgesehen ist;
- ein Vergleicher vorgesehen ist, der zum Vergleich des Inhalts eines mit einem zweiten Takt getakteten Vergleichs-Zählers mit dem Inhalt einer im Schreib-Lese-Speicher speicherbaren Zeittabelle dient und zur Steuerung der Selektierung durch die Adreßeinrichtung in Abhängigkeit von dem Ergebnis des Vergleichs dient.

Dabei bestimmt die Speicherkapazität des Schreib-Lesespeichers die Anzahl sowie die Komplexität der Digitalsignale (= Steuersignale). Die Selektierung der Steuersignale, d.h. eines bestimmten Zustandes aller Steuersignale übernimmt als Adreßeinrichtung beispielsweise ein Adreßzähler, der diesen Zustand mit Hilfe einer im Schreib-Lese-Speicher zugeordneten Adresse identifiziert. Zur Erzeugung der Steuersignale ist somit lediglich die Aktivierung, d.h. die Selektierung der jeweiligen Steuersignale notwendig, so daß ein zugeordneter Steuerrechner lediglich minimal belastet wird. Außerdem wird durch die einfache Angabe der jeweiligen Adressen von einzelnen Steuersignalen eine völlige Freiheit der Wahl der Reihenfolge der Steuersignale ermöglicht. Der Schreib-Lese-Speicher ermöglicht zudem durch einfaches Überschreiben bisheriger Steuersignale die Eingabe von neuen Signalverläufen eines Steuersignals.

Eine hohe zeitliche Auflösung der Digitalsignale ergibt sich dadurch, daß die Einrichtung zur Erzeugung der Digitalsignale einen Vergleicher aufweist, der vorgesehen ist zum Vergleich des Inhalts eines insbesondere mit einem Vielfachen eines Taktes der Digitalsignale getakteten Vergleichs-Zählers mit dem Inhalt einer im Schreib-Lese-Speicher speicherbaren Zeittabelle. Dieser Vergleichszähler steuert in Abhängigkeit von dem Ergebnis des Vergleichs die Adreßeinrichtung.

Arbeitet der Vergleichszähler beispielsweise mit dem vierfachen Bittakt der Steuersignale als sogenannter QuarterBit-Counter, ergibt sich eine Auflösung der Steuersignale von einem Viertel Bit. In der Zeittabelle des Schreib-Lese-Speichers sind dann für jedes Steuersignal beispielsweise sämtliche bei dieser Auflösung möglichen Startzeitpunkte eines Zeitrahmens aufgelistet. Ein bestimmter Zustand der Steuersignale wird somit erst dann selektiert, wenn sowohl die Adresse der Adreßeinrichtung mit der vorgegebenen Adresse als auch die in der Zeittabelle enthaltene Information des Startzeitpunkts mit dem vorgegebenen Startzeitpunkt übereinstimmt.

Bei einem nach einem Zeitvielfachzugriffsverfahren arbeitenden Funksendeempfänger kann eine Synchronisation der Digitalsignale dadurch erfolgen, daß die Einrichtung zur Erzeugung der Digitalsignale Synchronisationsmittel aufweist, die vorgesehen sind zur Synchronisation des Zeitrahmens der Digitalsignale mit einem vorgebbaren Zeitrahmen und/oder zur Synchronisation für einen vorgebbaren Zeitabschnitt eines ersten Zeitrahmens mit einem hierzu asynchronen weiteren Zeitrahmen, wobei der Bezug zum ersten Zeitrahmen aufrechterhalten wird. Kommt es beispielsweise während des Betriebs eines Mobilfunktelefons zu einer Veränderung der Signallaufzeit der Steuersignale, so kann mit Hilfe der Synchronisationsmittel wieder eine Synchronisation der Steuersignale (=Digitalsignale) mit dem vorgebbaren, insbesondere mit dem empfangenen Zeitrahmen erfolgen. Dies geschieht beispielsweise durch Einschieben bzw. Weglassen eines zusätzlichen Taktes des Vergleichszählers. Bei einem zellular aufgebauten Mobilfunksystem wird es ermöglicht, zwischen dem Zeitrahmen verschiedener beispielsweise benachbarter Funkzellen hin und her zu wechseln, wenn die Synchronisationsmittel für einen vorgebbaren Zeitabschnitt eine Synchronisation eines ersten Zeitrahmens mit einem hierzu asynchronen weiteren Zeitrahmen bewirken, wobei der Bezug zum ersten Zeitrahmen aufrecht erhalten wird.

Ist der Schreib-Lese-Speicher in mindestens zwei jeweils getrennt selektierbare Bereiche unterteilt, so besteht die Möglichkeit, sehr schnell zwischen verschiedenen Betriebsarten, d.h. zwischen verschiedenen Sätzen von Steuersignalen, umzuschalten. Darüber hinaus kann ein gerade unbenutzter Teil des Schreib-Lese-Speichers ohne Zeitprobleme vom Steuerrechner bearbeitet werden.

Ist im Schreib-Lese-Speicher mindestens ein Unterbrechungssignalge speichert, so kann mit Hilfe des Unterbrechungssignals beispielsweise einmal pro Zeitrahmen entsprechend einer gewünschten Anforderung eine Unterbrechung vorgegeben werden. Damit ist auch die Umschaltung auf einen anderen Betriebsmodus in Form von anderen in einem zweiten Bereich des Schreib-Lese-Speichers gespeicherten Steuersignalen möglich.

Ist die Einrichtung als integrierte Halbleiterschaltung realisiert, so wird insbesondere bei Mobilfunktelefonen die Möglichkeit geschaffen, die gesamte Einrichtung zur Erzeugung der verschiedensten Steuersignale platzsparend auch in einem Gehäuse mit geringen Außenabmessungen zu integrieren. Ist die Einrichtung als integrierte Peripheriefunktion auf einem Mikroprozessor realisiert, so kann beispielsweise ein bei einem Funk-Sende-Empfänger ohnehin vorhandener Mikroprozessor auch gleichzeitig die gesamte Einrichtung zur Erzeugung der Steuersignale aufnehmen.

Eine einfache Bereitstellung von Digitalsignalen, insbesondere für ein nach einem Zeitvielfachzugriffsverfahren arbeitenden Mobilfunksystem wird dadurch ermöglicht, daß die Digitalsignale zur Steuerung eines Funksendeempfängers eines Funkübertragungssystems vorgesehen sind.

Ist das digitale Übertragungssystem ein Mobilfunksystem und die Einrichtung in einer Mobil- und/oder Feststation des digitalen Mobilfunksystems integriert, so sind mit einer derartigen Einrichtung die beispielsweise beim paneuropäischen Mobilfunksystem vorgegebenen Anforderungen erfüllbar.

Im folgenden wird die Erfindung anhand der in den Figuren dargestellten Ausführungsbeispiele näher erläutert.

Es zeigen:
Fig. 1 ein vereinfachtes Blockschaltbild einer Einrichtung zur Erzeugung von Steuersignalen,
Fig. 2 den Verlauf verschiedener Steuersignale,
Fig. 3 ein Blockschaltbild einer Einrichtung zur Erzeugung von Steuersignalen,
Fig. 4 einen Funksendeempfänger,
Fig. 5 ein zellular aufgebautes Mobilfunksystem.

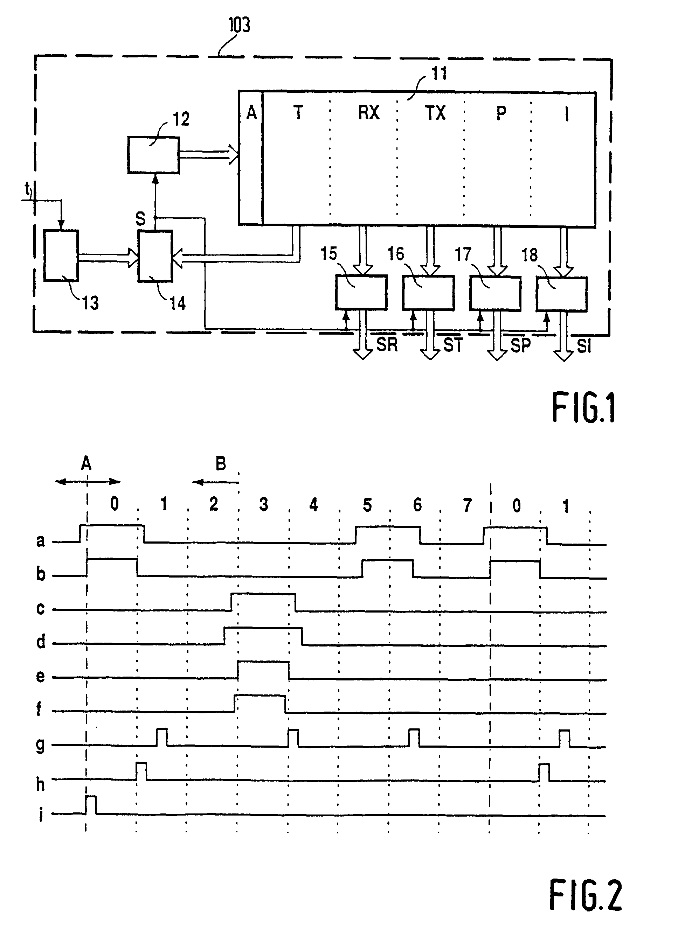

Das in Fig. 1 dargestellte Blockschaltbild zeigt ein Ausführungsbeispiel zur Erzeugung von Digitalsignalen. Diese Digitalsignale können beispielsweise Steuersignale für die verschiedenen Funktionen (z.B. Sender, Empfänger) eines digitalen Funkübertragungssystems sein, die sich in einem aus mehreren Zeitschlitzen bestehenden Zeit-Rahmen wiederholen. So arbeiten beispielsweise Funkgeräte, die nach dem Zeitvielfachzugriffsverfahren (Time division multiple access TDMA) betrieben werden, und beispielsweise für das zukünftige gesamteuropäische Mobilfunksystem GSM (Groupe spéciale mobile) benötigt werden. Dabei ist eine präzise zeitliche Steuerung vieler Funktionen erforderlich. Dies geschieht mit einer Vielzahl von Steuersignalen, die meist periodischen Verlauf zeigen, aber auch abhängig von zahlreichen unterschiedlichen Bedingungen individuell beeinflußbar sein sollen. Dazu sind bei dem in Fig. 1 dargestellten Ausführungsbeispiel die Steuersignale in einem Schreib-Lese-Speicher 11 gespeichert. Der Schreib-Lese-Speicher 11 ist in eine Zeittabelle T, Signaltabellen RX, TX, eine Pulstabelle P sowie eine Interrupttabelle I gegliedert. Der Inhalt der Zeittabelle T wird mittels eines Vergleichers 14 mit dem Inhalt eines Vergleichs zählers 13 verglichen. Der Vergleichszähler 13 wird dabei mit einem Takt t getaktet, der einem Vielfachen des Taktes der Steuersignale entspricht. Bei Gleichheit wird über eine Steuerleitung S mittels eines Adreßzählers 12 und einem im Schreib-Lese-Speicher 11 enthaltenen Adreßdekoders A das zugehörige Steuersignal aus der Signaltabelle RX, TX selektiert. Die Steuerleitung S ist darüber hinaus an Zwischenspeicher 15, 16, 17, 18 angeschlossen. Über diese Zwischenspeicher 15 bis 18 werden jeweils die aus den Signaltabellen RX, TX, aus der Pulstabelle P sowie der Interrupttabelle I eingelesenen Informationen als Signale SR, ST, SP, SI ausgegeben.

Das zentrale Element des in Fig. 1 dargestellten Ausführungsbeispiels einer Einrichtung zur Erzeugung von zeitabhängigen Funktionen bildet der Schreib-Lese-Speicher 11. Jede Zeile des Schreib-Lese-Speichers 11 ist in fünf Bereiche untergliedert und weist ein bestimmtes Steuersignalkennzeichen in den Informationen auf. So ist im Bereich der Zeittabelle T in jeder Zeile der genaue Startzeitpunkt des in derselben Zeile im Bereich der Signaltabelle RX, TX eingetragenen Steuersignals gespeichert. Beträgt beispielsweise der Takt t des Vergleichszählers 13 das Vierfache des Bittaktes der Steuersignale, so sind für jedes Steuersignal während jeder Bitperiode des vorgegebenen Zeitrahmens vier Startzeitpunkte möglich. Im Bereich der Signaltabelle RX sind beispielsweise sämtliche den Empfänger (Receiver) und im Bereich der Signaltabelle TX den Sender (Transmitter) betreffenden Steuersignale eingetragen. Im Bereich der Pulstabelle P sind Informationen zum Auslösen von Synchronisationssignalen eingetragen, die beispielsweise zur Synchronisation der Steuersignale in jeder Ausgangsleitung einen Impuls generieren. Außerdem kann mittels der Pulstabelle P eine Synchronisation des Zeitrahmens der Steuersignale mit dem empfangenen Zeitrahmen erfolgen. Eine weitere Möglichkeit besteht darin, temporär eine Synchronisation des Zeitrahmens der Steuersignale mit einem weiteren gegenüber dem vorgegebenen Zeit-rahmen asynchronen Zeitrahmen zu erzeugen, ohne daß der Bezug zum vorgegebenen Zeitrahmen verloren geht. Der Inhalt der Interrupttabelle I kann über den Zwischenspeicher 18 beispielsweise an einen in Fig. 1 nicht dargestellten Interruptgenerator weitergegeben werden.

Das Funktionsprinzip der in Fig. 1 dargestellten Einrichtung verläuft somit im wesentlichen in folgenden Schritten. Der Inhalt beispielsweise der ersten Zeile der Zeittabelle T wird mittels des Vergleichers 14 mit dem Inhalt des Vergleichszählers 13 verglichen. Der Vergleichszähler 13 wird dabei beispielsweise mit dem Vierfachen des Taktes des Zeitrahmens getaktet und mit diesem Takt fortlaufend inkrementiert. Die Periode des Vergleichszählers entspricht somit genau einem Zeitrahmen. Stellt der Vergleicher 14 Gleichheit zwischen dem Inhalt des Vergleichs-zählers 13 und dem Inhalt der Zeittabelle T fest, so laufen folgende Funktionen ab.

Der Inhalt der Signaltabellen RX, TX wird in die Zwischen speicher 15, 16 geladen und als Steuersignale SR, ST nach außen gegeben. Die in der Pulstabelle enthaltenen Informationen werden in den Zwischenspeicher 17 geladen und als Steuersignal SP beispielsweise an eine in der Fig. 1 nicht dargestellte Einrichtung weitergegeben, die an jeder Ausgangsleitung einen Puls generiert. So wird beispielsweise ein Puls dann generiert, wenn der zugehörige Inhalt eine logische "1" ist, andernfalls erfolgt keine Reaktion. Die Pulslänge beträgt dabei beispielsweise 1/8 Bit. Der Inhalt der Interrupttabelle I wird beispielsweise an einen in Fig. 1 nicht dargestellten Interruptgenerator weitergegeben, der beispielsweise eine Interruptleitung zu einem Steuerrechner (Host processor) aktiviert. Ist dieser Vorgang abgeschlossen, so wird der Vergleichszähler 14 inkrementiert. Damit erscheint im Vergleicher 14 ein neuer Zeitwert. Wenn der Vergleichszähler diesen Zeitwert erreicht hat, laufen die oben beschriebenen Vorgänge erneut ab.

Die in Fig. 1 angegebene Struktur ermöglich es somit, für die genannten Werte mit einer Auflösung von einem Viertel Bit zu beliebigen Zeitpunkten innerhalb des vorgegebenen Zeitrahmens, eine oder mehrere Steuersignale ein- bzw. auszuschalten, einen oder mehrere verschiedene Impulse zu erzeugen oder einen Interrupt zu generieren. Diese Funktionen können auch beliebig kombiniert werden. Dazu ist es lediglich erforderlich, daß die "Ereignisse", d.h. die im Schreib-Lese-Speicher gespeicherten Informationen, in der Reihenfolge ihres Auftretens, d.h. nach wachsenden Werten der Zeittabelle T sortiert eingetragen sind. Die in Fig. 1 dargestellte Einrichtung ermöglicht somit die Erzeugung einer beliebigen Anzahl von Steuersignalen mit hoher zeitlicher Auflösung und Flexibilität der erzeugten Steuersignale bei gleichzeitig minimaler Belastung des steuernden Rechners. Eine noch flexiblere Handhabung der in Fig. 1 dargestellten Einrichtung kann dadurch erreicht werden, daß der Schreib-Lese-Speicher 11 und die zugehörige Zeittabelle T, die Signaltabellen RX, TX sowie die Puls- und Interrupttabellen P bzw. I in mehrere unabhängige Teile zerlegt werden. Eine Aktivierung des jeweiligen Teils des Schreib-Lese-Speichers 11 erfolgt dann durch eine vom Steuerrechner dem Adreßzähler 12 vorgebbare Information. Damit besteht die Möglichkeit, die Einrichtung sehr schnell zwischen zwei unterschiedlichen Betriebsarten mit beliebig verschiedenen Steuersignalen umzuschalten. Darüber hinaus kann ein gerade unbenutzter Tabellenteil vom Steuerrechner ohne Zeitprobleme bearbeitet werden.

Fig. 2 zeigt ein Beispiel für zu erzeugende Steuersignale a bis i. Randbedingungen bei der Realisierung derartiger Steuersignale ist, daß einerseits die erforderlichen Steuersignale weitgehend selbständig mit möglichst geringer Inanspruchnahme des steuernden Rechners erzeugt werden, zum anderen soll ein hoher Grad an Flexibilität beispielsweise in bezug auf den Startzeitpunkt der Steuersignale gewährleistet sein, um eine Anpassung an unterschiedliche Gerätekonfigurationen eines Mobilfunksystems zu ermöglichen. Eine derartige Flexibilität stellt die Verwendbarkeit in späteren Gerätegenerationen sicher oder ermöglicht den Einsatz einer derartigen als integrierte Halbleiterschaltung ausgebildeten Einrichtung auch bei Geräten anderer Hersteller.

Die in Fig. 2 dargestellten Signalverläufe a bis i wiederholen sich jeweils in einem in sieben Zeitschlitze 0 bis 7 unterteilten Zeitrahmen. Dabei sind die Signale a bis f beispielsweise in den Signaltabellen RX, TX der in Fig. 1 dargestellten Einrichtung gespeicherte Steuersignale, während die Signale g bis i beispielsweise in der Impulstabelle P bzw. der Interrupttabelle I gespeicherte Synchronisations- bzw. Interruptsignale darstellen (Fig 1). Durch den Doppelpfeil A zu Beginn des ersten Zeitfensters des Zeitrahmens ist symbolisiert, daß mit der in Fig. 1 dargestellten Einrichtung eine Synchronisation des gesamten Zeitrahmens mit dem empfangenen Zeitrahmen ermöglicht wird. Der mit B gekennzeichnete Pfeil symbolisiert die Möglichkeit, beispielsweise durch Signallaufzeiten hervorgerufene Abweichungen einmal innerhalb eines Zeitrahmens zu korrigieren. Dies erfolgt beispielsweise durch Weglassen oder Einschieben eines zusätzlichen Taktes auf Anforderung durch den steuernden Rechner. Durch diese swallow/insert-Funktion wird der Zeitrahmen um ein Viertel Bit verkürzt oder verlängert. Die folgenden Zeitrahmen verschieben sich entsprechend.

Bei einem für das zukünftige gesamteuropäische Mobilfunksystem (GSM = Groupe spéciale mobile) vorgesehenen Einrichtungen erfüllen die in Fig. 2 dargestellten Signale beispielsweise folgende Aufgaben:
Bereitstellung von Signalen zur Steuerung des Zeitvielfachzugriffsverfahrens
Steuerung des Signalprozessors für die Basisbandverarbeitung
Steuerung der Software eines digitalen Signalprozessors Übernahme aller Hardware Steuer- und Überwachungsaufgaben.

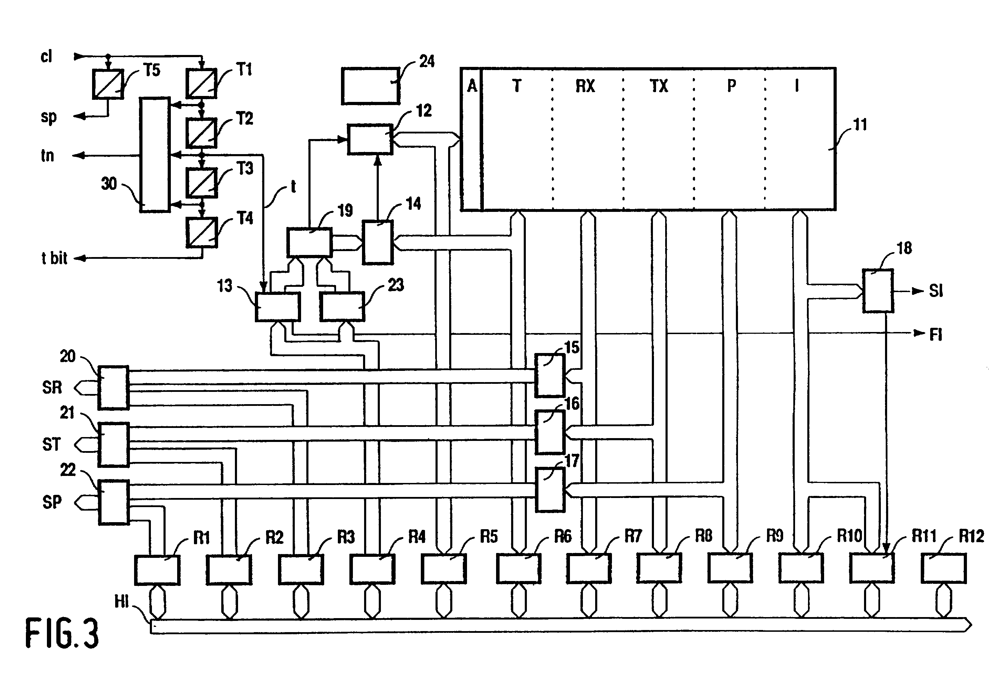

Fig. 3 zeigt ein ausführliches Blockschaltbild einer Einrichtung zur Erzeugung von Steuersignalen. Dabei wurden für die bereits im Zusammenhang mit Fig. 1 eingeführten Blöcke die gleichen Bezugszeichen verwendet. Das zentrale Element ist dabei wiederum der Schreib-Lese-Speicher 11, der in die Zeittabelle T, die Signaltabellen RX, TX sowie die Pulstabelle P und Interrupttabelle I unterteilt ist. Sämtliche in der Einrichtung der Fig. 3 benötigte Taktsignale werden aus einem Eingangstakt cl gewonnen. So wird ein Takt sp mit Hilfe eines Taktteilers T5 für die Digitalisierung des Audio-Signals gewonnen. über Taktteiler T1, T2, T3 sind Vielfache des Eingangstaktes cl ableitbar. Diese Vielfachen des Eingangstaktes werden einem Multiplexer 30 zugeführt, an dessen Ausgang ein gewünschter Bittakt tn auswählbar ist. In Reihe zu den Taktteilern T1, T2, T3 ist ein weiterer Taktteiler T4 geschaltet, der einen Bittakt tbit liefert. Wie bereits im Zusammenhang mit Fig. 1 ausgeführt wurde, wird der Vergleichszähler 13 mit einem Takt t getaktet, der ein Vielfaches des Taktes tbit der Steuersignale beträgt. Zusätzlich zu dem in Fig. 1 dargestellten Ausführungsbeispiel ist bei der in Fig. 3 dargestellten Einrichtung zwischen den Vergleichszähler 13 und den Vergleicher 14 ein Offset-Addierer 19 eingeschaltet. Über 12 Register Rl bis R12 ist die Einrichtung mittels einer Datenbusleitung HI mit dem Steuerrechner verbindbar. Eine Ausgabe der Steuersignale SR, ST, SP erfolgt über Ausgaberegister 20, 21, 22.

Der Offset-Addierer 19 ermöglicht eine Verschiebung des Zeitrahmens gegenüber dem Zeitrahmen einer Nachbarzelle in einen mobilen Funkübertragungssystem. Dabei errechnet ein über einen Steuerbus HI angeschlossener Steuerrechner (Host interface) den Offset relativ zur sogenannten bedienenden Station (Serving cell). Dieser Offset ist beipielsweise durch Lauf zeitverzögerungen hervorgerufen. Das Komplement des so ermittelten Offset wird über einen Zwischenspeicher 23 mittels des Offset-Addierers 19 zum Inhalt des Vergleichszählers 13 addiert. Das Ergebnis dieser Addition bildet das Eingangssignal für den Vergleicher 14. Für die Offset-Behandlung ist noch eine weitere Funktion erforderlich, da nach dem Ändern des Wertes im Offset-Zwischenspeicher 23 der Adreßzähler 12 in der Regel auf einen falschen Tabelleneintrag in der Zeittabelle T zeigt. Aus diesem Grund ist es erforderlich, den Adreßzähler 12 richtigzustellen, da sonst durch das Ändern des Offset im ungünstigsten Fall ein ganzer Zeitrahmen verlorengehen kann. Dazu wird nach jeder Änderung des Inhalts des Offset-Registers R4 der Adreßzähler 12 zurückgesetzt. Der Adreßzähler 12 inkrementiert dann solange, wie die zum jeweiligen Inhalt des Adreßzählers 12 gehörigen Tabelleneinträge in der Zeittabelle T kleiner als der Wert am Ausgang des Offset-Addierers 19 sind. Die Inhalte des Sektionen RX, TX, P, I des Schreib-Lese-Speichers 11 werden dabei ignoriert, d.h. die Ausgänge bleiben unverändert und es werden keine Synchronisationsimpulse sowie Interrupts erzeugt. Der Adreßzähler 12 zeigt dadurch auf den ersten Tabelleneintrag der Zeittabelle T, der größer als der augenblickliche Stand aus der Summe des Inhalts des Vergleichs zählers 13 und des Offset ist. Mit diesem Verfahren ist sichergestellt, daß der Adreßzähler 12 schnellstmöglich richtiggestellt wird und die Ausgangszustände direkt vom alten in den neuen Zustand übergehen. Mit Hilfe eines Signals FI (Frame Interrupt), das beispielsweise aus einem Puls der Länge 1/8 bit besteht, kann nach dem Laden des Offset-Register R4 der Beginn des ersten Zeitrahmens mit korrekter Einstellung des Vergleichszählers 13 markiert werden.

Über die als Datenbus ausgebildete Verbindung HI werden zwölf Register (R1 bis R12) für den Steuerrechner zugänglich. So wird über das Steuerregister R12 beispielsweise die Synchronisation oder die Auswahl des gewünschten Bittaktes kontrolliert. Das Register R5 ist das Adreßregister für den Zugriff auf die Zeittabelle. Durch dieses Register kann gekennzeichnet werden, welche Zeile der Zeittabelle T durch einen Schreib-Lese-Zugriff auf eines Register (R6 bis R10) beschrieben oder gelesen wird.

Die Register R6 bis R10 bilden temporäre Register für das Schreiben/Lesen der einzelnen Sektionen der Zeittabelle T. Wie bereits erwähnt, bildet das Register R4 das Zeitoffsetregister. Die Register R1 bis R3 bilden die Maskenregister. So kann beispielsweise durch eine in diese Register eingetragene "0" die korrespondierende Signalleitung auf "0" festgehalten werden. Das Register R11 bildet das Interruptvektorregister. Eine Kontrollfunktion 24 koordiniert alle Abläufe innerhalb der in Fig. 3 dargestellten Einrichtung. Eine Ausgabe der Steuersignale SR, ST, SP erfolgt schließlich über die Ausgaberegister 20, 21, 22.

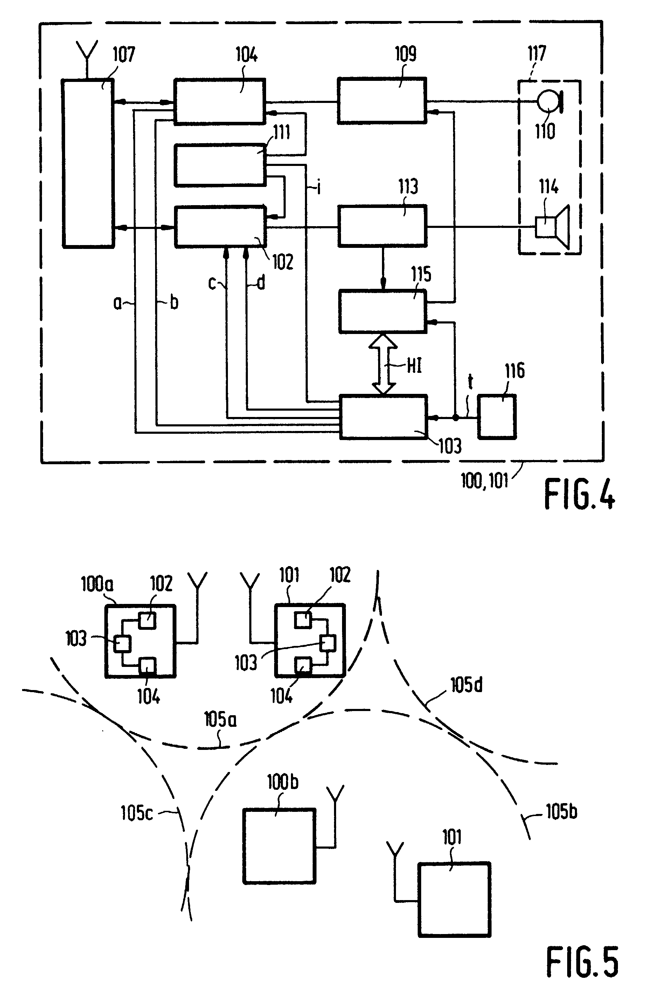

Figur 4 zeigt einen schematischen Aufbau eines Funksendeempfängers 100, 101 mit einer Einrichtung 103 zur Erzeugung von Steuersignalen a, b, c, d. Der Funksendeempfänger 100, 101 weist einen Diplexer 107 mit einer Antenne auf. Der Diplexer 107 ist mit einem Sender 104 und einem Empfänger 102 verbunden. Der Sender 104 ist über einen Modulator 103 an ein Mikrophon 110 beispielsweise eines Bedienhörers 117 angeschlossen. Der Bedienhörer 117 weist außerdem einen Lautsprecher 114 auf, der über deinen Demodulator 113 an den Empfänger 102 angeschlossen ist. Der Sender 104 und der Empfänger 102 werden von einem Frequenzerzeuger 111 angesteuert, dem ein Steuersignal i zugeführt wird. Der Funksendeempfänger 100, 101 weist darüber hinaus eine an den Modulator 109, an den Demodulator 113 sowie an die Einrichtung 103 zur Erzeugung der Steuersignale angeschlossene Steuereinheit 115 auf. Außerdem ist ein Taktgenerator 116 vorgesehen, der einen Takt cl an die Einrichtung 103 zur Erzeugung der Steuersignale sowie an die Steuereinheit 115 liefert. Die Einrichtung 103 zur Erzeugung der Steuersignale und die Steuereinheit 115 sind über eine Verbindung HI miteinander verbunden.

Der in Figur 4 dargestellte Funksendeempfänger 100, 101 arbeitet nach einem Zeitvielfachzugriffsverfahren (Time Division Multiple Access TDMA) und kommt beispielsweise beim gesamteuropäischen Mobilfunksystem GSM zum Einsatz. Dabei ist eine präzise zeitliche Steuerung der Funktionen des Senders 104 und des Empfängers 102 sowie des Frequenzerzeugers 111 erforderlich. Diese Steuerung erfolgt mit Hilfe von Steuersignalen a..i, die mit Hilfe der Einrichtung 103 erzeugt werden. Die Erzeugung der Steuersignale a..i ist im Zusammenhang mit Figuren 1 bis 3 erläutert.

Figur 5 zeigt ein zellular aufgebautes Mobilfunksystem. Dieses besteht aus Feststationen 100a, 100b, sowie aus Mobilstationen 101. Die Mobilstationen 101 sind beispielsweise Mobilfunktelefone in einem Kraftfahrzeug, einem Zug etc. angeordnet, oder als Handfunkmobiltelefone ausgebildet. Das Mobilfunksystem besteht aus einzelnen Funkzellen 105a, 105b, 105c, 105d, wobei von den Funkzellen 105c, 105d, lediglich die Randbereiche dargestellt sind. Jede Fest- 100a, 100b sowie jede Mobilstation 101 weist unter anderem eine Sendeeinrichtung 102 sowie eine Empfangseinrichtung 104 auf. Die Sende- 102 und Empfangseinrichtungen 104 ermöglichen die Übertragung von Funksignalen zwischen Feststation 100a, 100b, sowie den Mobilstationen 101. Hierzu sind jeder Fest- 100a, 100b und Mobilstation 101 jeweils eine Antenne zugeordnet. Darüberhinaus weist jede Fest- 100a, 100b und Mobilstation 101 eine Einrichtung 103 zur Erzeugung von Steuersignalen auf.

Bei dem in Figur 5 dargestellten Mobilfunkübertragungssystem handelt es sich beispielsweise um das gesamteuropäische Mobilfunksystem GSM, bei dem Steuersignale benötigt werden, die sich in einem aus mehreren Zeitschlitzen bestehenden Zeitrahmen wiederholen. Die Steuersignale steuern die verschiedenen Funktionen, insbesondere von der Sendeeinrichtung 102 sowie der Empfangseinrichtung 104. Die mit Hilfe der Einrichtung 103 erzeugten Steuersignale erfüllen darüber hinaus insbesondere folgende Aufgaben: Bereitstellung von Signalen zur Steuerung des Zeitvielfachverfahrens, der zeitlichen Steuerung des Prozessors für die Basisbandverarbeitung sowie der Steuerung der Software eines digitalen Steuerprozessors. Die Einrichtung 103 weist einen Schreib-/Lesespeicher auf, wie bereits im Zusammenhang mit den Figuren 1 und 3 beschrieben worden ist, wobei die Selektierung der Steuersignale mittels einer dem Schreib-/Lesespeicher zugeordneten Adreßeinrichtungen erfolgt. Die Einrichtung 103 weist ein Synchronisationsmittel auf, die für einen vorgebbaren Zeitabschnitt eine Synchronisation eines ersten Zeitrahmens, der beispielsweise durch die Funkzelle 105a vorgegeben ist, mit einem hierzu asynchronen weiteren Zeitrahmen, der beispielsweise durch die Funkzelle 105b vorgegeben ist, ermöglichen. Dabei wird der Bezug zum ersten Zeitrahmen der Funkzelle 105a aufrechterhalten, wodurch es bei dem zellularaufgebautem Mobilfunksystem entsprechend der Figur 5 ermöglicht wird, zwischen dem Zeitrahmen benachbarter Funkzellen 105a und 105b hin- und herzuwechseln.

## Patentansprüche

1. Einrichtung zur Erzeugung von sich im wesentlichen in einem vorgebbaren Zeitrahmen wiederholenden und mit einem ersten Takt getakteten Digitalsignalen (a..i) für ein Funkübertragungssystem mit
- einem Schreib-Lese-Speicher (11), der zur Speicherung von Signalverläufen der Digitalsignale (a..i) vorgesehen ist;
- einer dem Schreib-Lese-Speicher (11) zugeordneten Adreßeinrichtung (12) zur Selektierung von im Schreib-Lese-Speicher (11) gespeicherten Signalverläufen für die Erzeugung der Digitalsignale (a..i);
- einem Vergleicher (14), der zum Vergleich des Inhalts eines mit einem zweiten Takt getakteten Vergleichs-Zählers (13) mit dem Inhalt einer im Schreib-Lese-Speicher (11) speicherbaren Zeittabelle (T) vorgesehen ist und der zur Steuerung der Selektierung durch die Adreßeinrichtung (12) in Abhängigkeit von dem Ergebnis des Vergleichs dient.

2. Einrichtung nach Anspruch 1,
dadurch gekennzeichnet,
daß der Vergleichs-Zähler (13) mit einem Vielfachen des Taktes der Digitalsignale (a..i) getaktet ist.

3. Einrichtung nach einem der Ansprüche 1 oder 2,
dadurch gekennzeichnet,
daß die Einrichtung (103) zur Erzeugung der Digitalsignale (a..i) Synchronisationsmittel (19, 23) aufweist, die vorgesehen sind zur Synchronisation des Zeitrahmens der Digitalsignale mit einem vorgebbaren Zeitrahmen und/oder zur Synchronisation für einen vorgebbaren Zeitabschnitt eines ersten Zeitrahmens mit einem hierzu asynchronen weiteren Zeitrahmen, wobei der Bezug zum ersten Zeitrahmen aufrechterhalten wird.

4. Einrichtung nach einem der Ansprüche 1 bis 3,
dadurch gekennzeichnet,
daß der zur Speicherung der Digitalsignale (a..i) vorgesehene Bereich des Schreib-Lese-Speicher (11) in mindestens zwei jeweils getrennt selektierbare Teilbereiche unterteilt ist.

5. Einrichtung nach einem der Ansprüche 1 bis 4,
dadurch gekennzeichnet,
daß im Schreib-Lese-Speicher (11) mindestens ein Unterbrechungssignal gespeichert ist.

6. Einrichtung nach einem der Ansprüche 1 bis 5,
dadurch gekennzeichnet,
daß die Einrichtung als integrierte Halbleiterschaltung oder als integrierte Peripheriefunktion auf einem Mikroprozessor realsisiert ist.

7. Einrichtung nach einem der Ansprüche 1 bis 6,
dadurch gekennzeichnet,
daß die Digitalsignale vorgesehen sind zur Steuerung eines Funksendeempfängers (100a, 100b, 101) eines Funkübertragungssystems.

8. Einrichtung nach einem der Ansprüche 1 bis 7,
dadurch gekennzeichnet,
daß das Funkübertragungssystem ein Mobilfunksystem ist und daß die Einrichtung in einer Mobil- (100) und/oder Feststation (101) des Mobilfunksystems integriert ist.

9. Einrichtung nach einem der Ansprüche 1 bis 8,
dadurch gekennzeichnet,
daß die Einrichtung für eine Mobil- und/oder Feststation eines Funkübertragungssystems vorgesehen ist, das nach einem Zeitvielfachzugriffsverfahren arbeitet.

10. Funksendeempfänger (100, 101) mit einer Einrichtung (103) nach einem der Ansprüche 1 bis 9.

## Claims

1. An arrangement for generating digital signals (a..i) recurring, in essence, in a predeterminable time frame and clocked with a first clock, for a radio transmission system with
- a read/write memory (11) used for storing signal variations of the digital signals (a..i);
- an address arrangement assigned to the read/write memory (11) used for selecting signal variations stored in the read/write memory (11) for the generation of the digital signals (a..i);
- a comparator (14) used for comparing the contents of a comparative counter (13) clocked with a second clock with the contents of a time table (T) that can be stored in the read/write memory (11) and for controlling the selection by the address arrangement (12) in dependence on the result of the comparison.

2. An arrangement as claimed in Claim 1, characterized in that the comparative counter (13) is clocked with a multiple of the clock of the digital signals (a..i).

3. An arrangement as claimed in one of the Claims 1 or 2, characterized in that the arrangement (103) for generating the digital signals (a..i) comprises synchronizing means (19, 23) for synchronizing the time frames of the digital signals with a predeterminable time frame and/or for synchronizing for a predeterminable time slot a first time frame with a further time frame asynchronous thereto, while the relationship to the first time frame is maintained.

4. An arrangement as claimed in one of the Claims 1 to 3, characterized in that the area of the read/write memory (11), which area is used for storing the digital signals (a..i), is subdivided into at least two separately selectable sub-areas.

5. An arrangement as claimed in one of the Claims 1 to 4, characterized in that at least one interrupt signal is stored in the read/write memory (11).

6. An arrangement as claimed in one of the Claims 1 to 5, characterized in that the arrangement is realized as an integrated semiconductor circuit or as an integrated peripheral function on a microprocessor.

7. An arrangement as claimed in one of the Claims 1 to 6, characterized in that the digital signals are used for controlling a radio transceiver (100a, 100b, 101) of a radio transmission system.

8. An arrangement as claimed in one of the Claims 1 to 7, characterized in that the radio transmission system is a mobile radio system and in that the arrangement is integrated with a mobile station (100) and/or base station (101) of the mobile radio system.

9. An arrangement as claimed in one of the Claims 1 to 8, characterized in that the arrangement is provided for a mobile station and/or base station of a radio transmission system which operates according to a time-division multiple access method.

10. A radio transceiver (100, 101) comprising an arrangement (103) as claimed in one of the Claims 1 to 9.

## Revendications

1. Générateur de signaux numériques cadencés à un premier rythme et se répétant dans un cadre temporel à déterminer préalablement (a...i) pour un système de transmission radio avec
- une mémoire d'écriture/lecture (11) qui est prévue pour l'enregistrement de tracés de signaux et des signaux numériques (a...i) ;
- un dispositif d'adressage (12) affecté à la mémoire d'écriture/lecture (11) en vue de la sélection de tracé de signaux enregistrés dans la mémoire d'écriture/lecture (11) pour la production des signaux numériques (a...i) ;
- un comparateur (14) qui est prévu pour la comparaison du contenu d'un compteur de comparaison (13) cadencé à un deuxième rythme avec le contenu d'un tableau de temps (T) à enregistrer dans la mémoire d'écriture/lecture (11) et qui sert à la commande de la sélection par le dispositif d'adressage (12) en fonction du résultat de la comparaison.

2. Dispositif selon la revendication 1, caractérisé en ce que le compteur de comparaison (13) est cadencé par un multiple du rythme des signaux numériques (a...i)

3. Dispositif selon l'une des revendications 1 ou 2, caractérisé en ce que le dispositif (103) en vue de la production des signaux numériques (a...i) présente des moyens de synchronisation (19, 23) qui sont prévus pour la synchronisation du cadre temporel des signaux numériques avec un cadre temporel à déterminer préalablement et/ou en vue de la synchronisation pour un segment temporel à déterminer préalablement d'un premier cadre temporel avec un cadre temporel supplémentaire asynchrone par rapport à celui-ci, le rapport au premier cadre temporel étant maintenu.

4. Dispositif selon l'une des revendications 1 à 3, caractérisé en ce que la zone de la mémoire d'écriture/lecture (11) prévue pour l'enregistrement des signaux numériques (a...i) est subdivisée en au moins deux zones partielles à sélectionner séparément.

5. Dispositif selon l'une des revendications 1 à 4, caractérisé en ce qu'au moins un signal d'interruption est enregistré dans la mémoire d'écriture/lecture (11).

6. Dispositif selon l'une des revendications 1 à 5, caractérisé en ce que le dispositif est réalisé comme un circuit intégré à semi-conducteurs ou comme une fonction périphérique intégrée sur un microprocesseur.

7. Dispositif selon l'une des revendications 1 à 6, caractérisé en ce que des signaux numériques sont prévus pour la commande d'un émetteur-récepteur radio (100a, 100b, 101) d'un système de transmission radio.

8. Dispositif selon l'une des revendications 1 à 7, caractérisé en ce que le système de transmission radio est un système de radiotéléphonie mobile et que le dispositif est intégré dans une station mobile (100) et/ou une station fixe (101) du système de radiotéléphonie mobile.

9. Dispositif selon l'une des revendications 1 à 8, caractérisé en ce que le dispositif est prévu pour une station mobile et/ou une station fixe d'un système de transmission radio qui fonctionne selon le procédé à accès multiple par répartition dans le temps.

10. Emetteur/récepteur radio (100, 101) avec un dispositif 103) selon l'une des revendications 1 à 9.
